# EUROPEAN PATENT APPLICATION

(11) **EP 1 335 429 A2**
(43) Date of publication of application: **13.08.2003**
(21) Application number: 03075265.3
(22) Date of filing: 27.01.2003
(51) Int. Cl.: H01L 27/00

(54) **A method for manufacturing an integrated display device including an oled display and a touch screen**

(30) Priority: 08.02.2002 US 71697
(71) Applicant: EASTMAN KODAK COMPANY, Rochester, New York 14650 (US)
(72) Inventor: Cropper, Andre Dominic, Rochester, New York 14650-2201 (US); Cok, Ronald S., Rochester, New York 14650-2201 (US); Feldman, Rodney D., Rochester, New York 14650-2201 (US); Williams, David J., Rochester, New York 14650-2201 (US)
(74) Representative: Weber, Etienne Nicolas

(57) **Abstract**

A method of manufacturing a display device having an OLED display and a touch screen, the OLED display including components that are sensitive to high temperatures, and the touch screen including a resistive film, includes the steps of: providing a transparent substrate having two sides; forming a flat-panel organic light emitting diode display on one side of the substrate; forming a resistive film using a low temperature technique on the other side of the substrate; and forming a resistive touch screen on the resistive film.

## Description

The present invention relates to a method for the manufacture of resistive wire touch screens on flat-panel displays with a common substrate.

Electronic devices typically include a computing engine, a display, and an interactive device responsive to the input of a user. For example, a computer may include a computing circuit, a CRT for display, and a keyboard and mouse responsive to a user's input. As a second example, a Personal Digital Assistant includes a computing circuit, an LCD display, and a touch screen formed over the LCD display, together with some buttons. Many electronic devices, in particular mobile devices, miniature devices, devices that require a reprogrammable interface, or devices that require a robust and simple user interaction mechanism rely upon touch screens placed over a display to provide user interaction capabilities to the device.

There are many touch screen technologies such as resistive wire, acoustic, and infra-red. These are generally placed above either a CRT screen or LCD screen to provide the required interactive functionality in a single component composed of two parts. Typically, the display (for example, LCD or CRT) is manufactured while the touch screen is made separately. After the display and touch screen are manufactured, they are integrated in a common housing to provide a single component that can be built into a complete electronic device. Resistive wire touch screens are built upon a substrate that has coated upon it a resistive film, typically indium tin oxide (ITO) at a specified thickness, uniformity and resistivity. Resistive touch screen materials, such as spacers, conductive films, etc., are carefully formed upon the coated substrate to create a resistive touch screen. When combined with a display, the multi-layer component has inferior optical characteristics to the display device alone due to inter-layer reflections, has redundant manufacturing steps, and redundant components. Moreover, the additional step of integrating the components raises manufacturing costs for the complete device. The manufacturing processes for display-and-touch-screen devices are well known in the art and products are available today from a variety of vendors. For example, US Patent 5,795,430 issued August 18, 1998 to Beeteson et al., describes an adhesive material dispensed onto a faceplate and used to attach a touch screen.

A new class of display devices based upon organic light-emitting diodes (OLEDs) is formed by depositing patterned conductive and organic materials upon a substrate. This substrate can be identical to the substrate used for resistive wire touch screens. Moreover, the materials used for the patterned conductive materials are similar to, or the same as, those used for the resistive films, but their uniformity, thickness and resistivity may vary. The OLED displays are made by patterning a conductive material that is formed on a substrate. For an OLED display, the conductive material is ideally a low resistivity film, whereas for a touch screen a controlled higher resistivity film is employed. If an active matrix display device is desired, electronic components such as transistors and capacitors are also formed on the patterned conductive material in a desired circuit design. Once the conductive pattern and electronic components are formed, organic materials are deposited, followed by any remaining conductive elements, planarization layers and other layers as known in the prior art. Connecting pads are defined as part of the conducting pattern and are wire-bonded to a cable after the device is encapsulated. The process by which the OLED display device is made uses well-known photo-lithographic, deposition, bonding, and encapsulation methods common-place in the integrated circuit industry. However, a problem exists with the conventional practice of forming separate OLED displays and touch screens and then combining them, in that the additional layers in the touch screen reduce the brightness of the display, reduces the optical quality of the display due to additional internal reflections from the layers of the touch screen, and add cost due to the need for two substrates and a complex housing for the two elements.

There is a need therefore for an improved method for manufacturing an integrated resistive touch screen and OLED display that reduces redundant components in the devices, reduces cost, improves optical qualities, and is more robust.

The need is met according to the present invention by providing a method of manufacturing a display device having an OLED display and a touch screen. The OLED display includes components that are sensitive to high temperatures, and the touch screen including a resistive film, includes the steps of: providing a transparent substrate having two sides; forming a flat-panel organic light emitting diode display on one side of the substrate; forming a resistive film using a low temperature technique on the other side of the substrate; and forming a resistive touch screen on the resistive film.

The present invention has the advantage that it reduces the number of components required to build an integrated OLED display and resistive touch screen device, reduces the number of manufacturing steps, reduces the manufacturing costs, reduces the combined size of the display and touch screen device, and provides superior optical performance.
Fig. 1 is a schematic side view of an integrated display device that can be manufactured according to the present invention; and
Fig. 2 is a flow chart showing the manufacturing steps of the present invention.

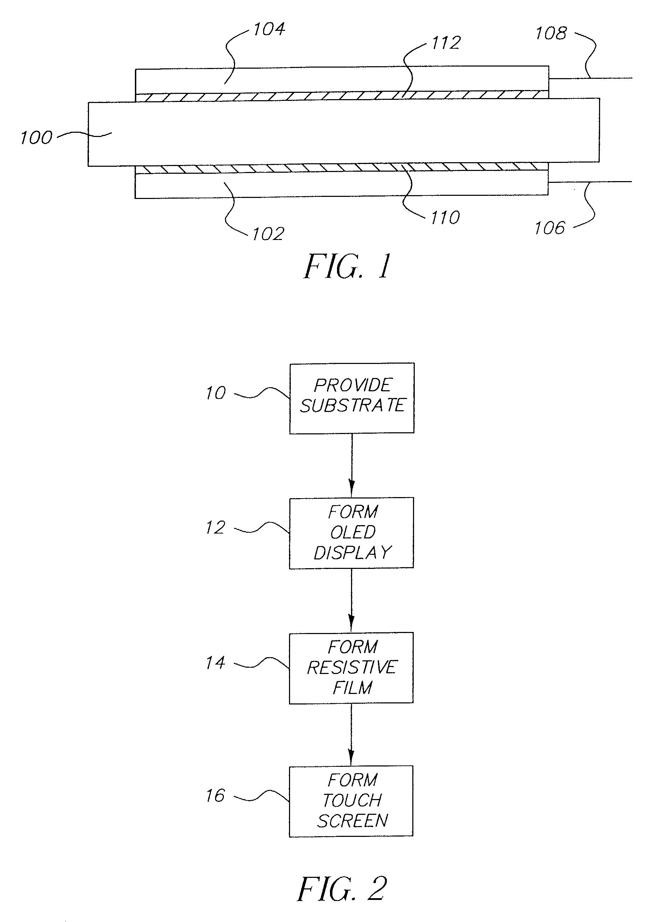

Referring to Fig. 1, a substrate 100 (typically glass or rigid polymer) having two parallel flat sides is used both for the OLED display 102 and the resistive touch screen 104. The OLED display 102 emits light through the substrate 100 and the resistive touch screen 104. The OLED display 102 is formed on a conductive film 110 that is patterned to provide conductors as is known in the art. The resistive touch screen 104 is formed on a uniform resistive film 112 as is known in the art. Connectors 106 and 108 are provided to the OLED display 102 and touch-screen 104 respectively for driving the display and receiving inputs from an operator of the display.

Conventionally, the resistive/conductive film, usually indium tin oxide (ITO), is deposited upon the substrate 100 using a high temperature (e.g. 200-400° C). If OLED materials are subjected to such high temperatures, their performance (lifetime, stability, color characteristics) can be adversely affected. Thus, it is preferable that any high temperature resistive/conductive film deposition steps be performed prior to the deposition of any OLED materials. In making a flat panel display and a touch screen on a common substrate, one possible approach is to perform the high temperature deposition steps for both the OLED display and the touch screen prior to deposition of the OLED materials. Unfortunately, conventional handling equipment used to manufacture OLED flat panel displays and touch screens contact the substrate from the back side, potentially causing damage to any previously formed resistive film layers. Furthermore, if an entire touch screen were to have been previously formed on one side of the substrate, the handling equipment used to make the OLED display would not function properly

Referring to Fig. 2, the integrated display and touch screen are formed according to one embodiment of the present invention by providing 10 a substrate suitable for forming a flat-panel display on one side and a touch screen on the opposite side. The flat-panel OLED display is formed 12 on one side of the substrate using conventional techniques and handling equipment known in the art. In particular, any process for forming the conductive layer for the OLED display may be used, regardless of temperature. Once the OLED display is made on one side of the substrate, a resistive film (preferably ITO) is formed 14 on the second side of the substrate using a low-temperature method such as the low temperature ITO sputtering technique provided by Thin Film Devices Inc., Anaheim Calif.

As used herein, low temperature method refers to methods that do not subject the substrate to temperatures higher than 150° C (preferably no higher than 100° C. By using a low-temperature sputtering method for forming the ITO layer for the touch screen, the temperature of the substrate is maintained at a temperature that is compatible with the organic materials used in the OLED displays. Once the resistive film is deposited on the second side of the substrate, a resistive touch screen is formed 16 on the resistive film. The remaining steps in the process by which the resistive touch screen is formed (once the resistive film has been deposited) are compatible with the OLED display on the other side of the substrate.

Alternatively, the resistive layer for the touch screen may be formed by a low temperature coating technique such as spin coating, web coating, or drop jet coating (for example using an ink-jet apparatus) of a resistive polymer such as polythiophene.

The method described with respect to Fig. 2 can be used for either passive- or active-matrix OLED displays, since the basic process is the same for either device. In the case of active-matrix displays, transistors, capacitors and related circuitry are patterned on the substrate before organic materials are deposited. Otherwise, the steps of forming initial conductive patterns, bonding connectors, and encapsulating the display are the same.

The low-temperature sputtering process used for depositing the resistive film on the second side of the substrate may involve placing the encapsulated display in a vacuum. To avoid any problem caused by internal pressure of any gas encapsulated within the display, adhesives such as epoxies, or wide bonding areas capable of withstanding pressures generated when the substrate is placed in a vacuum are used to encapsulate the display prior to forming the resistive layer.

## Claims

1. A method of manufacturing a display device having an OLED display and a touch screen, the OLED display including components that are sensitive to high temperatures, and the touch screen including a resistive film, comprising the steps of:
a) providing a transparent substrate having two sides;
b) forming a flat-panel organic light emitting diode display on one side of the substrate;
c) forming a resistive film using a low temperature technique on the other side of the substrate; and
d) forming a resistive touch screen on the resistive film.

2. The method claimed in claim 1, wherein the low temperature technique is low temperature sputtering.

3. The method claimed in claim 1, wherein the low temperature technique is coating a resistive polymer material.

4. The method claimed in claim 3, wherein the coating technique is spin coating.

5. The method claimed in claim 3, wherein the coating technique is web coating.

6. The method claimed in claim 3, wherein the coating technique is drop jet coating.

7. The method claimed in claim 3, wherein the resistive polymer material is polythiophene.

8. The method claimed in claim 1, wherein the OLED display is an active matrix display.

9. The method claimed in claim 1, wherein the OLED display is a passive matrix display.

10. A display device manufactured according to the method of claim 1.

11. The method claimed in claim 1, wherein the resistive film is indium tin oxide (ITO).
